# EUROPEAN PATENT APPLICATION

(11) **EP 4 603 949 A1**
(43) Date of publication of application: **20.08.2025**
(21) Application number: 23878659.4
(22) Date of filing: 16.06.2023
(51) Int. Cl.: G06F 1/18

(54) **HEAT EXCHANGE ASSEMBLY, COLD PLATE ASSEMBLY, AND TERMINAL DEVICE**

(30) Priority: 19.10.2022 CN 202211282473
(71) Applicant: Huawei Cloud Computing Technologies Co., Ltd., Guiyang, Guizhou 550025 (CN)
(72) Inventor: DONG, Xiaoyu, Guiyang, Guizhou 550025 (CN); YAO, Xidong, Guiyang, Guizhou 550025 (CN)
(74) Representative: Maiwald GmbH
(86) International application number: PCT/CN2023/100886
(87) International publication number: WO 2024/082662

(57) **Abstract**

Embodiments of this application provide a heat exchange assembly, a cold plate assembly, and a terminal device. The heat exchange assembly includes a main part and a positioning part. The main part has a heat exchange cavity that is configured to accommodate a cooling medium, and a liquid inlet and a liquid outlet that are connected to the heat exchange cavity. The positioning part is configured to fit a first fitting part disposed on a holder, to position relative positions of the holder and the heat exchange assembly. The cold plate assembly includes the heat exchange assembly and the holder. The holder includes a body part and the first fitting part. The body part is configured to enable the first fitting part to abut against the positioning part of the heat exchange assembly, so that the main part of the heat exchange assembly abuts against a heat generating component. The cold plate assembly is decoupled to obtain two parts: the heat exchange assembly and the holder, and the heat exchange assembly has the heat exchange cavity and can cover a plurality of types and generations of heat generating components. Therefore, the heat exchange assembly does not need to be repeatedly developed, which helps reduce development costs of the cold plate assembly.

## Description

This application claims priority to Chinese Patent Application No. 202211282473.6, filed with the China National Intellectual Property Administration on October 19, 2022 and entitled "HEAT EXCHANGE ASSEMBLY, COLD PLATE ASSEMBLY, AND TERMINAL DEVICE", which is incorporated herein by reference in its entirety.

### TECHNICAL FIELD

Embodiments of this application relate to the field of heat dissipation technologies, and in particular, to a heat exchange assembly, a cold plate assembly, and a terminal device.

### BACKGROUND

With rapid development of information technologies, a service volume of a data center industry increases, and an amount of heat generated by servers in a data center also increases exponentially. Heat generating components such as a central processing unit (central processing unit, CPU) and a memory are disposed inside the server. An excessively high temperature of the heat generating component may cause performance degradation of the heat generating component or even damage the heat generating component. Therefore, a heat dissipation mechanism (for example, a cold plate assembly) is disposed in the server to perform liquid cooling heat dissipation on the heat generating component, so that the heat generating component operates within an appropriate temperature range.

In a related technology, a central processing unit is mounted on a substrate through a CPU socket, and a cold plate assembly is covered on a surface of the central processing unit. The cold plate assembly has a holder structure that is fastened to the CPU socket, and the holder structure may enable the cold plate assembly to be in close contact with the central processing unit. The central processing unit may exchange heat with a cooling medium in the cold plate assembly, and the cooling medium takes away heat generated by the central processing unit in a circularly flowing process, so that the central processing unit operates within an appropriate temperature range. Each type of central processing unit corresponds to a CPU socket. Therefore, when the central processing unit is iterated or manufactured by different manufacturers, the CPU socket needs to be redesigned, and consequently a holder structure that fits the CPU socket also needs to be redesigned. However, because the cold plate assembly is of an integrated structure, the entire cold plate assembly needs to be redeveloped.

Therefore, when the central processing unit is iterated or manufactured by different manufacturers, a corresponding cold plate assembly needs to be redesigned, which causes high development costs of the cold plate assembly.

### SUMMARY

Embodiments of this application provide a heat exchange assembly, a cold plate assembly, and a terminal device. The cold plate assembly is decoupled to obtain a heat exchange assembly and a holder that are of a split structure, and the heat exchange assembly may cover a plurality of types and generations of central processing units. Therefore, the entire cold plate assembly does not need to be redesigned, which can reduce development costs of the cold plate assembly.

A first aspect of this application provides a heat exchange assembly, including a main part and a positioning part. The main part has a heat exchange cavity that is configured to accommodate a cooling medium, and a liquid inlet and a liquid outlet that are connected to the heat exchange cavity. The positioning part is configured to fit a first fitting part disposed on a holder, to position relative positions of the holder and the heat exchange assembly.

The heat exchange assembly provided in embodiments of this application includes the main part and the positioning part. The main part has an independent heat exchange cavity and is configured to contact a heat generating component. The heat exchange cavity may be configured to accommodate a liquid cooling medium. The positioning part and the first fitting part on the holder may fit each other to position relative positions of the main part and the holder. The heat exchange assembly may be fastened to the heat generating component through the holder, so that the cooling medium in the heat exchange assembly can dissipate heat for the heat generating component. The cold plate assembly is decoupled to obtain the holder and the heat exchange assembly that are of a split structure, the heat exchange assembly has the independent heat exchange cavity, and the heat exchange assembly may cover a plurality of types and generations of heat generating components. Therefore, after the heat generating component is iterated or manufactured by different manufacturers, the heat exchange assembly does not need to be redesigned, and only the holder needs to be redesigned, which avoids redesigning the entire cold plate assembly. In addition, reliability testing such as air tightness, durability and corrosion resistance, and aging testing does not need to be performed repeatedly. This can reduce an introduction difficulty and development costs.

In a possible implementation, the positioning part is sleeved on the main part and defines a step surface together with a side wall of the main part.

Because the positioning part is sleeved on the main part, a fitting area between the positioning part and the first fitting part can be increased on a premise of positioning the relative positions of the heat exchange assembly and the holder. This helps reduce a difficulty in fitting between the positioning part and the first fitting part, and can improve a speed of assembling the heat exchange assembly with the holder.

In a possible implementation, there are at least two positioning parts, and the at least two positioning parts are spaced from each other in a circumferential direction of the main part.

Because the at least two positioning parts are spaced from each other in the circumferential direction of the main part, a size of space occupied by the positioning parts may be reduced. This helps dispose the heat exchange assembly in an environment with compact space. In addition, in this way, a scope of use of the heat exchange assembly can be broadened.

In a possible implementation, the heat exchange assembly further includes a fastening part. The fastening part is disposed on one of the main part and the positioning part, and the fastening part is configured to fit a second fitting part disposed on the holder, to fasten the heat exchange assembly and the holder.

The heat exchange assembly and the holder may be fastened in advance through fitting between the fastening part and the second fitting part. This helps reduce a difficulty in assembling the cold plate assembly with the heat generating component.

In a possible implementation, the fastening part is disposed on the main part, one of the fastening part and the second fitting part is an elastic bump, and the other is a fitting groove for inserting the elastic bump.

The elastic bump is inserted into the fitting groove to form a clamping relationship, so that a simple constraint relationship can be formed, to prevent the heat exchange assembly and the holder from being accidentally separated. In addition, a process of fitting between the elastic bump and the fitting groove is simple, which helps reduce a difficulty in fastening the heat exchange assembly and the holder.

In a possible implementation, the fastening part is disposed on the positioning part, one of the fastening part and the second fitting part is a clamping hook, and the other is a clamping groove or a clamping block clamped to the clamping hook.

A clamping relationship is formed between the clamping hook and the clamping block or the clamping groove, so that the cold plate assembly can be assembled in advance before the cold plate assembly is assembled with the heat generating component. This helps reduce time for assembling the cold plate assembly with the heat generating component.

In a possible implementation, the heat exchange assembly includes a cover plate, a skived fin plate, and a support plate. The cover plate, the skived fin plate, and a part of the support plate jointly define the heat exchange cavity and are used as the main part, the liquid inlet and the liquid outlet are disposed on the cover plate, and another part of the support plate is used as the positioning part.

An independent heat exchange cavity may be formed in the heat exchange assembly jointly formed by the cover plate, the skived fin plate, and the support plate, and the heat exchange assembly covers a plurality of types and generations of heat generating components. This can reduce development costs of the cold plate assembly. In addition, when the heat exchange assembly is assembled with the heat generating component, the relative positions of the heat exchange assembly and the holder may be positioned, so that the holder may fasten the heat exchange assembly to the heat generating component.

A second aspect of this application provides a cold plate assembly, including a holder and the heat exchange assembly according to any one of the implementations of the first aspect. The holder includes a body part and a first fitting part. When the cold plate assembly is configured to dissipate heat for a heat generating component, the first fitting part fits a positioning part of the heat exchange assembly to position relative positions of the holder and the heat exchange assembly, and the body part is configured to enable a main part of the heat exchange assembly to abut against the heat generating component.

The cold plate assembly provided in embodiments of this application is decoupled to obtain the holder and the heat exchange assembly. The heat exchange assembly has the independent heat exchange cavity, and the heat exchange assembly may cover a plurality of types and generations of heat generating components. Therefore, when the heat generating component is iterated or manufactured by different manufacturers, the heat exchange assembly does not need to be redesigned, and only the holder needs to be redesigned. This can shorten a development cycle and reduce development costs of the cold plate assembly.

In a possible implementation, the body part is of an annular structure, and the first fitting part is disposed on a bottom surface of the body part.

The use of the body part of the annular structure can increase a fitting area between the first fitting part and the positioning part. This helps reduce a difficulty in positioning the holder and the heat exchange assembly.

In a possible implementation, the body part includes two holder bodies, and one first fitting part is disposed on a bottom surface of each holder body.

The use of two holder bodies helps broaden a scope of use of the cold plate assembly. For example, the cold plate assembly is used in an environment with narrow space.

A third aspect of this application provides a terminal device, including a heat generating component and the cold plate assembly according to any one of the implementations of the second aspect. The cold plate assembly is configured to dissipate heat for the heat generating component.

In a possible implementation, the terminal device is a server.

### BRIEF DESCRIPTION OF DRAWINGS

FIG. 1 is a three-dimensional diagram of a structure of a cold plate assembly according to an embodiment of this application;
FIG. 2 is a bottom view of a cold plate assembly according to an embodiment of this application;
FIG. 3 is an exploded view of a cold plate assembly according to an embodiment of this application;
FIG. 4 is a sectional view of a cold plate assembly according to an embodiment of this application;
FIG. 5 is a three-dimensional diagram of a structure of a heat exchange assembly according to an embodiment of this application;
FIG. 6 is an exploded view of a heat exchange assembly according to an embodiment of this application;
FIG. 7 is a sectional view of a heat exchange assembly according to an embodiment of this application;
FIG. 8 is a three-dimensional diagram of a cover plate in a first direction according to an embodiment of this application;
FIG. 9 is a three-dimensional diagram of a cover plate in a second direction according to an embodiment of this application; and
FIG. 10 is a three-dimensional diagram of a holder according to an embodiment of this application.

### Reference numerals:

10: cold plate assembly;
20: heat exchange assembly;
21: main part;
   211: avoidance groove;
22: positioning part;
23: liquid inlet;
24: liquid outlet;
25: fastening part;
   251: connection part;
   252: bump part;
26: cover plate;
   261: sealing groove;
27: skived fin plate;
   271: bottom plate part;
      2711: first bottom plate section;
      2712: second bottom plate section;
   272: skived fin part;
28: support plate;
   281: annular groove;
29: sealing ring;
30: holder;
   31: body part;
   32: first fitting part;
   33: second fitting part;
41: fastening plate;
   411: first opening;
   412: second opening;
42: screw;
43: positioning block;
44: second positioning groove;
51: liquid inlet connector;
52: liquid outlet connector.

### DESCRIPTION OF EMBODIMENTS

Terms used in embodiments of this application are only used to explain specific embodiments of this application, but are not intended to limit this application.

With rapid development of information and communication technologies, a quantity and power density of electronic elements in a terminal device (for example, a server such as a rack server or a cabinet server) increases rapidly, contributing to increasingly high performance of the terminal device. Naturally, more heat is generated when the terminal device runs. If the heat generated by the terminal device cannot be dissipated in time, a temperature of a component of the terminal device increases, which may cause performance degradation of the component, shorten a service life of the component, or even damage the component. Therefore, how to enable a component of a terminal device to operate within an appropriate temperature range becomes a problem to be urgently resolved.

It should be noted that, in addition to the server such as the rack server or the cabinet server, the terminal device may include but is not limited to a device such as a desktop computer, a notebook computer, a vehicle-mounted computer, a medical terminal, or a computing device.

The following uses an example in which a server is a terminal device to describe how to dissipate heat for a component, to ensure that the component operates within an appropriate temperature range. The server may include a substrate, a heat generating component, and a heat dissipation mechanism. The heat generating component is mounted on the substrate. The heat dissipation mechanism is configured to dissipate heat for the heat generating component.

The heat generating component may be a component such as a memory, a power supply, a circuit board, a resistor, a central processing unit, a graphics processing unit, or a capacitor. It should be noted that, when the heat generating component is the central processing unit, a CPU socket (CPU socket) is disposed on the substrate, and the central processing unit is mounted on the substrate through the CPU socket.

In addition to dissipating heat for the heat generating component through the heat dissipation mechanism, in some embodiments, a heat generating component with high performance and low energy consumption may be used. For example, a central processing unit with high performance and low power consumption is used.

A heat dissipation manner of the heat dissipation mechanism for the heat generating component may be air cooling or liquid cooling. For example, in some embodiments, the heat dissipation mechanism may include a fan disposed inside the terminal device, to perform air cooling heat dissipation on the heat generating component. However, air cooling heat dissipation efficiency is low. In addition, power consumption of the fan is high, and electricity consumption is high, which is not conducive to energy saving.

When the heat dissipation mechanism performs liquid cooling heat dissipation on the heat generating component, because a liquid cooling medium may be in contact with or not in contact with the heat generating component, there are a plurality of heat dissipation structures. This is not specifically limited herein. For example, in some embodiments, the heat dissipation mechanism may include a cavity that accommodates a heat generating component and a liquid cooling medium. The heat generating component is immersed in the liquid cooling medium, and the cooling medium exchanges heat with the heat generating component and takes away heat generated by the heat generating component in a circularly flowing process, thereby implementing single-phase liquid cooling heat dissipation.

In some other embodiments, the heat dissipation mechanism may include a cavity that accommodates a heat generating component and a liquid cooling medium. The heat generating component is immersed in the liquid cooling medium, the cooling medium changes from liquid to gas after absorbing heat generated by the heat generating component, and when leaving the cavity, the gaseous cooling medium takes away the heat generated by the heat generating component, thereby implementing two-phase heat dissipation.

In still some other embodiments, the heat dissipation mechanism may be a cold plate assembly 10. The cold plate assembly 10 is in close contact with a heat generating component, the heat generating component exchanges heat with a liquid cooling medium in the cold plate assembly 10, and the cooling medium takes away heat of the heat generating component in a circularly flowing process, thereby implementing single-phase liquid cooling heat dissipation.

It should be noted that different heat generating components may use different heat dissipation manners. In other words, a corresponding heat dissipation mechanism may be selected based on an amount of heat generated by the heat generating component. For example, a central processing unit may use liquid cooling heat dissipation, and a battery uses air cooling heat dissipation.

Because the central processing unit generates a large amount of heat, a cold plate assembly may be used to perform single-phase liquid cooling heat dissipation on the central processing unit. In addition, the central processing unit is mounted on a substrate through a CPU socket, and the cold plate assembly covers a surface of the central processing unit and is fastened to the CPU socket, so that the central processing unit may be in close contact with the cold plate assembly. In this way, it can be ensured that the central processing unit operates within an appropriate temperature range.

In a related technology, a cold plate assembly may include a housing structure and a holder structure. The housing structure is configured to define a cavity that accommodates a cooling medium, the cooling medium exchanges heat with a central processing unit through the housing structure, and the holder structure is disposed on the housing structure and is configured to be fastened to a CPU socket, so that the housing structure can be in close contact with the central processing unit. The holder structure and the housing structure may form an integrated structure in a manner of threaded connection, welding, or the like.

The cold plate assembly in the related technology may dissipate heat for the central processing unit. However, when the central processing unit is iterated or manufactured by different manufacturers, a structure of the central processing unit changes, and correspondingly, a structure of the CPU socket also changes. The cold plate assembly in the related technology is of an integrated structure and is designed based on the CPU socket. This means that the cold plate assembly in the related technology can correspond to only one CPU socket, and the entire cold plate assembly needs to be redesigned when the CPU socket changes. In a process of redesigning the cold plate assembly, reliability testing such as air tightness, durability and corrosion resistance, and aging testing and verification need to be performed. It is well known that an iteration speed of a central processing unit is high and there are many types of central processing units. Therefore, a corresponding cold plate assembly needs to be repeatedly developed, and reliability testing and verification need to be repeatedly performed. This causes high development costs of the cold plate assembly, and causes a long development cycle and high introduction costs of the cold plate assembly.

For the foregoing problem, an embodiment of this application provides a cold plate assembly 10. The cold plate assembly 10 is decoupled to obtain a heat exchange assembly 20 and a holder 30 that may be independent of each other. The heat exchange assembly 20 defines a heat exchange cavity that accommodates a cooling medium, and the cooling medium exchanges heat with a central processing unit through the heat exchange assembly 20. The holder 30 is configured to be fastened to a CPU socket, and enables the heat exchange assembly 20 to be in close contact with the central processing unit, so that the heat exchange assembly 20 can enable the cooling medium to dissipate heat for the central processing unit. Because the heat exchange assembly 20 and the holder 30 are independent of each other, and the heat exchange assembly 20 has the independent heat exchange cavity, reliability testing such as air tightness, durability and corrosion resistance, and aging testing and verification can be performed. **In** addition, a size of the heat exchange assembly 20 is designed, so that the heat exchange assembly 20 can cover a plurality of types and generations of central processing units, and a scope of use of the heat exchange assembly 20 can be broadened. Therefore, when the central processing unit is replaced, only the holder 20 needs to be replaced or redesigned, the heat exchange assembly 20 does not need to be redesigned, and reliability testing and verification do not need to be repeatedly performed. This can shorten a development cycle and reduce development costs of the cold plate assembly 10.

It should be noted that the cold plate assembly 10 provided in this application may be configured to dissipate heat for a heat generating component integrated on a substrate. For example, the central processing unit is integrated on the substrate. In this case, the holder 30 is fastened to the substrate, and the heat exchange assembly 20 may still cover a plurality of types and generations of central processing units.

The following uses an example in which a heat generating component is central processing to describe an implementation of the cold plate assembly 10 in embodiments of this application.

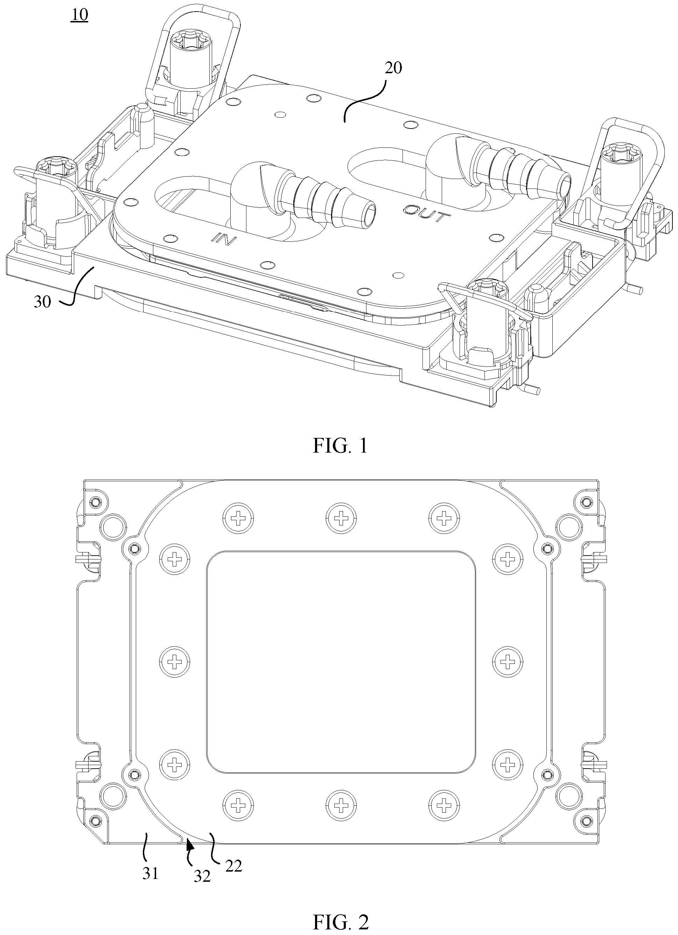

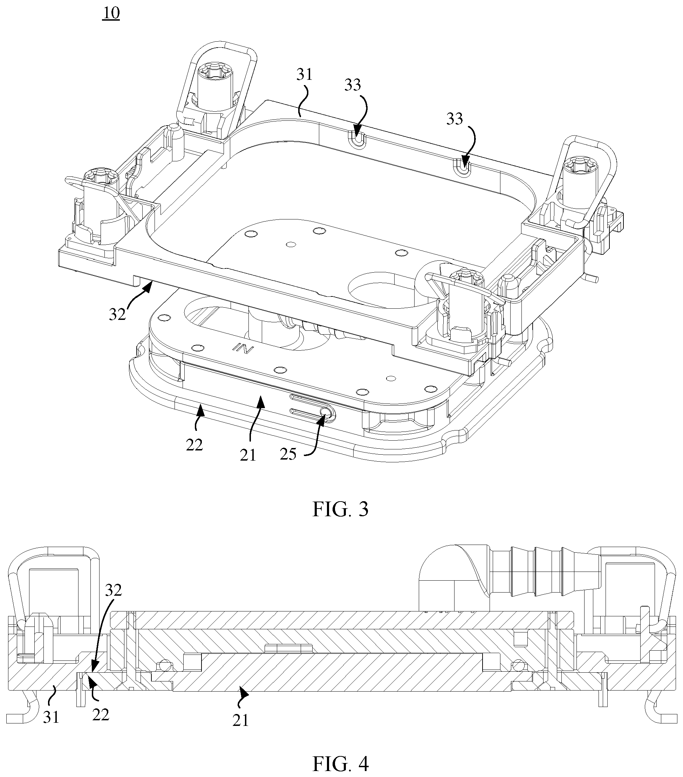

FIG. 1 is a three-dimensional diagram of a structure of a cold plate assembly according to an embodiment of this application. FIG. 2 is a bottom view of a cold plate assembly according to an embodiment of this application. FIG. 3 is an exploded view of a cold plate assembly according to an embodiment of this application. FIG. 4 is a sectional view of a cold plate assembly according to an embodiment of this application.

Refer to FIG. 1 and FIG. 2. A cold plate assembly 10 in embodiments of this application may include a heat exchange assembly 20 and a holder 30. Refer to FIG. 3 and FIG. 4. The heat exchange assembly 20 may include a main part 21 and a positioning part 22. The main part 21 has a heat exchange cavity that is configured to accommodate a cooling medium, and a liquid inlet 23 and a liquid outlet 24 that are connected to the heat exchange cavity. When the main part 21 is in contact with a heat generating component, the cooling medium exchanges heat with the heat generating component through the main part 21, to reduce a temperature of the heat generating component. The positioning part 22 is configured to fit a first fitting part 32 disposed on the holder 30. In this way, when the cold plate assembly 10 dissipates heat for the heat generating component, relative positions of the holder 30 and the heat exchange assembly 20 can be positioned, to ensure that the holder 30 can fasten the heat exchange assembly 20 to the heat generating component, so that the main part 21 is in close contact with the heat generating component. The holder 30 may include a body part 31 and the first fitting part 32. The body part 31 is configured to be fastened to a CPU socket. In this way, the main part 21 may abut against the heat generating component, so that the heat exchange assembly 20 can be fixed on a surface of the heat generating component to dissipate heat for the heat generating component.

The liquid inlet 23 is configured to be connected to an outlet of a cooling medium supply apparatus, and the liquid outlet 24 is configured to be connected to an inlet of the cooling medium supply apparatus (not shown in the figure). The cooling medium supply apparatus may transfer a liquid cooling medium to the heat exchange cavity, and may change a high-temperature cooling medium that flows into the cooling medium supply apparatus from the cold plate assembly 10 to a low-temperature cooling medium, so that the cooling medium circularly flows.

In some embodiments, the cooling medium supply apparatus may include a heat exchanger, a liquid inlet pipe, a liquid outlet pipe, and a transfer pump. An input end of the transfer pump is connected to an output end of the heat exchanger, an output end of the transfer pump is connected to the liquid inlet 23 through the liquid inlet pipe, and the liquid outlet 24 is connected to an input end of the heat exchanger through the liquid outlet pipe.

When the cold plate assembly 10 dissipates heat for the heat generating component, a flow path of the cooling medium is as follows: The cooling medium in the heat exchange cavity absorbs heat generated by the heat generating component and changes to a high-temperature cooling medium, the high-temperature cooling medium enters the heat exchanger through the liquid outlet pipe and changes to a low-temperature cooling medium through the heat exchanger, and the low-temperature cooling medium may enter the heat exchange cavity through the transfer pump, to absorb again heat generated by the heat generating component.

In embodiments of this application, the cooling medium may be water, fluoride liquid, a refrigerant, or the like. This is not limited herein.

The cooling medium exchanges heat with the heat generating component through the main part 21. Therefore, to improve a heat dissipation capability of the heat generating component, the main part 21 covers the heat generating component. In addition, a cross-sectional shape of the main part 21 may be determined based on a shape of the heat generating component. This is not specifically limited herein. For example, when the heat generating component is a central processing unit, a cross-sectional shape of the main part 21 may be a rectangular shape.

Because the main part 21 has an independent heat exchange cavity, and the heat exchange cavity may be configured to accommodate a cooling medium, reliability testing and verification related to liquid cooling can be performed. In addition, because the heat exchange assembly 20 may cover a plurality of types and generations of heat generating components, the heat exchange assembly 20 does not need to be redesigned for different CPU sockets. This can reduce development costs of the heat exchange assembly 20 and development costs of the cold plate assembly 10.

After the heat exchange assembly 20 is assembled with the holder 30 to form the cold plate assembly 10 shown in FIG. 4, the positioning part 22 and the first fitting part 32 may fit each other to position relative positions of the main part 21 and the body part 31. Then, after the body part 31 is fastened to the CPU socket, the main part 21 may be fastened to the central processing unit, and the heat exchange assembly 20 does not fall off from the heat generating component.

Because the body part 31 is fastened to the CPU socket (not shown in the figure), a pressing force exists between the CPU socket and the body part 31. The pressing force may be transferred to the main part 21 through the positioning part 22 and the first fitting part 32, so that the main part 21 abuts against the heat generating component, and the holder 30 may press the heat exchange assembly 20 onto the heat generating component.

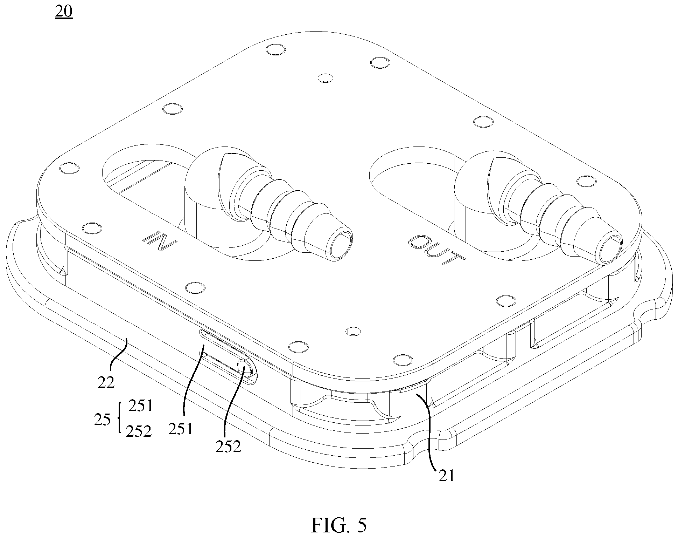

FIG. 5 is a three-dimensional diagram of a structure of a heat exchange assembly according to an embodiment of this application. In a possible implementation, as shown in FIG. 4 and FIG. 5, the positioning part 22 may be of an annular structure, and the positioning part 22 is sleeved on the main part 21 and defines a step surface together with a side wall of the main part 21. In this way, a fitting area between the positioning part 22 and the first fitting part 32 can be increased on a premise of positioning the relative positions of the heat exchange assembly 20 and the holder 30. This helps reduce a difficulty in fitting between the positioning part 22 and the first fitting part 32, and can improve a speed of assembling the heat exchange assembly 20 with the holder 30.

As shown in FIG. 4, a bottom end face of the positioning part 22 may be flush with a bottom end face of the main part 21. In this way, a difficulty in manufacturing the positioning part 22 and the main part 21 can be reduced. In addition, a thickness of the cold plate assembly 20 may be further reduced. In addition, a heat exchange area of the heat exchange assembly 20 may be further increased by using the positioning part 22.

Certainly, the bottom end face of the positioning part 22 is flush with the bottom end face of the main part 21. In some embodiments, the bottom end face of the positioning part 22 may alternatively be above the bottom end face of the main part 21 and below a top end face of the main part 21. This helps increase a thickness of the positioning part 22, thereby increasing a connection area between the positioning part 22 and the main part 21, and further improving connection strength between the positioning part 22 and the main part 21.

A fitting structure of the positioning part 22 and the first fitting part 32 is not specifically limited herein. For example, in some embodiments, as shown in FIG. 4, a first groove for inserting the positioning part 22 is disposed on a bottom surface of the body part 31, and the positioning part 22 is inserted into the first groove, to position relative positions of the main part 21 and the body part 31.

In some embodiments, a top surface of the positioning part 22 has a second groove (not shown in the figure), and the first fitting part 32 is configured to be inserted into the second groove to position the relative positions of the main part 21 and the body part 31. There are at least two second grooves, and the at least two second grooves are spaced from each other in a circumferential direction of the main part 21.

In some embodiments, a plurality of third grooves (not shown in the figure) that are spaced from each other in a circumferential direction of the positioning part 22 are disposed on a side wall of the positioning part 22. There are also a plurality of first fitting parts 32, and each first fitting part 32 is inserted into a corresponding third groove, to position the main part 21 and the body part 31. Certainly, the fitting structure of the positioning part 22 and the first fitting part 32 is not limited to the foregoing three structures.

There is one positioning part 22. In a possible implementation, there are alternatively at least two positioning parts 22, and the at least two positioning parts 22 are spaced from each other in the circumferential direction of the main part 21 (not shown in the figure), so that the relative positions of the heat exchange assembly 20 and the holder 30 can still be ensured. A specific structure of the positioning part 22 is not specifically limited herein. For example, the positioning part 22 may be of a block structure, a plate structure, a rod structure, or the like.

The fitting structure of the fitting part 32 and the positioning part 22 is not specifically limited herein. For example, in some embodiments, there are a plurality of first fitting parts 32. The plurality of first fitting parts 32 are in one-to-one correspondence with a plurality of positioning parts 22. The plurality of first fitting parts 32 are fourth grooves disposed on the bottom surface of the body part 31 in a circumferential direction. The positioning part 22 is inserted into the fourth groove.

In some embodiments, there are a plurality of positioning parts 22 and a plurality of first fitting parts 32. The plurality of positioning parts 22 are in one-to-one correspondence with the plurality of first fitting parts 32. Each positioning part 22 is of an annular structure. The first fitting part 32 is inserted into the positioning part 22. The first fitting part 32 may be of a structure such as a rod structure or a block structure. This is not limited herein.

In some embodiments, there are a plurality of positioning parts 22 and a plurality of first fitting parts 32. The plurality of positioning parts 22 are in one-to-one correspondence with the plurality of first fitting parts 32. A fifth groove for inserting the first fitting part 32 is disposed on the top surface of each positioning part 22.

In some embodiments, there are a plurality of positioning parts 22 and a plurality of first fitting parts 32. The plurality of positioning parts 22 are in one-to-one correspondence with the plurality of first fitting parts 32. Each positioning part 22 is provided with a positioning notch that penetrates the positioning part 22. The first fitting part 32 penetrates the positioning notch. It may be understood that the fitting structure of the positioning part 22 and the first fitting part 32 is not limited to the foregoing several structures.

In a possible implementation, the heat exchange assembly 20 may further include a fastening part 25. The fastening part 25 is disposed on one of the main part 21 and the positioning part 22. A second fitting part 33 that fits the fastening part 25 is disposed on the holder 30. Through fitting between the fastening part 25 and the second fitting part 33, before the cold plate assembly 10 is in contact with the heat generating component, the heat exchange assembly 20 and the holder 30 may be fastened in advance, to preliminarily assemble the cold plate assembly 10. This helps reduce a difficulty in assembling the cold plate assembly 10 with the heat generating component.

A fitting manner of the fastening part 25 and the second fitting part 33 may include but is not limited to a manner of threaded connection, clamping, abutting connection, magnetic connection, or the like. In addition, specific structures of the fastening part 25 and the second fitting part 33 may be determined based on a specific fitting manner. This is not specifically limited herein.

In some embodiments, as shown in FIG. 3 and FIG. 5, the fastening part 25 is disposed on the side wall of the main part 21. The fastening part 25 may be an elastic bump. The second fitting part 33 is a fitting groove for inserting the elastic bump. The second fitting part 33 is disposed on a side wall of the body part 31. The elastic bump is inserted into the fitting groove to form a clamping relationship, so that the heat exchange assembly 20 and the holder 30 can be fastened before the cold plate assembly 10 is in contact with the heat generating component. In addition, a fitting manner of the elastic bump and the fitting groove is simple, which can reduce a difficulty in fastening the heat exchange assembly 20 and the holder 30, and no tool (for example, a screwdriver) is required.

As shown in FIG. 5, the elastic bump may include a connection part 251 and a bump part 252. Two ends of the connection part 251 are respectively fastened to the bump part 252 and the main part 21. The elastic bump is elastic. Therefore, in a process of assembling the heat exchange assembly 20 with the holder 30, the bump part 252 may be automatically inserted into the fitting groove, and the elastic bump can be clamped to the fitting groove to form a constraint relationship.

Still refer to FIG. 5. The bump part 252 may be of a hemispheroidal structure, which may reduce a difficulty in inserting the bump part 252 into the fitting groove or withdrawing the bump part 252 from the fitting groove.

Still refer to FIG. 3. To reduce the difficulty in inserting the bump part 252 into the fitting groove, one end of the fitting groove extends to a top surface of the body part 31.

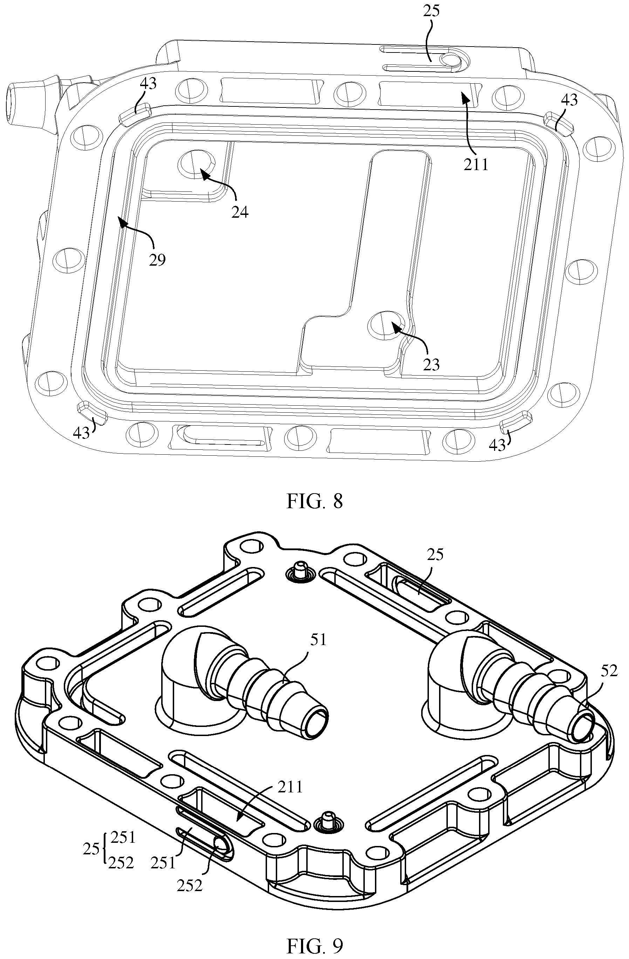

To ensure that the elastic bump can be detached from the fitting groove, an avoidance groove 211 (as shown in FIG. 8) may be disposed on the side wall of the main part 21. The avoidance groove 211 is configured to accommodate the elastic bump. Specifically, in a process in which the elastic bump is detached from the fitting groove, the elastic bump deforms and extends into the avoidance groove 211, so that the holder 30 and the heat exchange assembly 20 may be separated.

It may be understood that, in addition to that the fastening part 25 may be the elastic bump and the second fitting part 33 is the fitting groove, in some embodiments, the second fitting part 33 may alternatively be an elastic bump, and the fastening part 25 may alternatively be a fitting groove.

In some embodiments, the second fitting part 33 may alternatively be a fastener (not shown in the figure) that is rotatably connected to the body part 31, and the fastening part 25 is disposed on a top surface of the main part 21 and is configured to be clamped to the fastener. In this way, the heat exchange assembly 20 and the holder 30 may still be fastened.

In some embodiments, the fastening part 25 may alternatively be disposed on the positioning part 22, the fastening part 25 may be a clamping hook (not shown in the figure), and the second fitting part 33 may be a clamping groove or a clamping block. The heat exchange assembly 20 and the holder 30 may be fastened by clamping the clamping hook to the clamping groove or the clamping block. It may be understood that, in some embodiments, the second fitting part 33 may alternatively be a clamping hook, and the fastening part 25 may alternatively be a clamping groove or a clamping block.

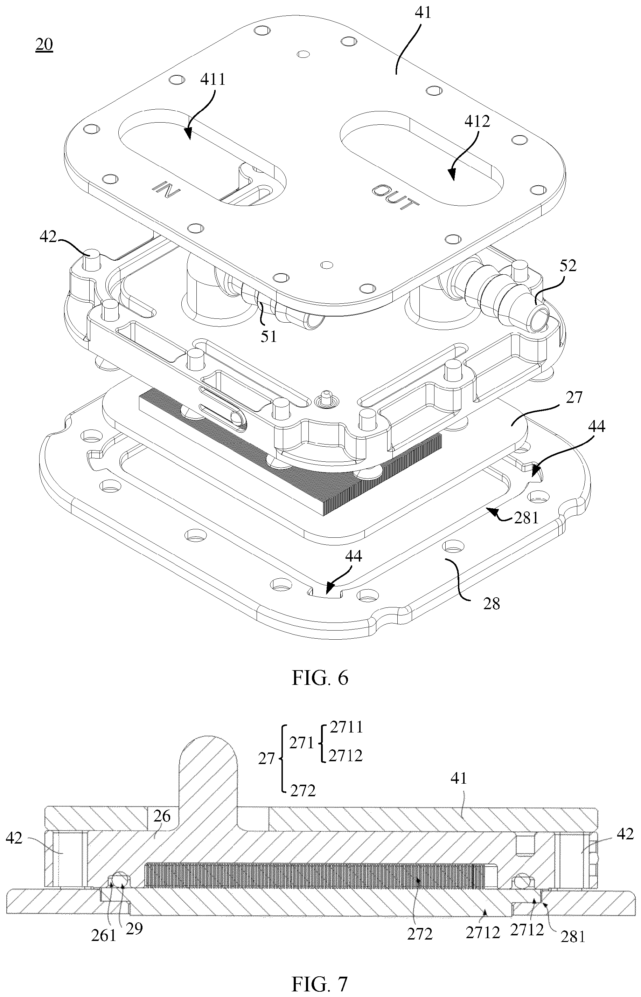

FIG. 6 is an exploded view of a heat exchange assembly according to an embodiment of this application. FIG. 7 is a sectional view of a heat exchange assembly according to an embodiment of this application. In a possible implementation, as shown in FIG. 5 and FIG. 7, the heat exchange assembly 20 may include a cover plate 26, a skived fin plate 27, and a support plate 28. The cover plate 26, the skived fin plate 27, and a part of the support plate 28 jointly define the heat exchange cavity and are used as the main part 21 in the foregoing content. Another part of the support plate 28 may be used as the positioning part 22 in the foregoing content. The liquid inlet 23 and the liquid outlet 24 are disposed on the cover plate 26, so that the cooling medium may enter or flow out of the heat exchange cavity. In this way, the independent heat exchange cavity can be formed, and the holder 30 can press the heat exchange assembly 20 tightly onto the heat generating component.

Still refer to FIG. 6 and FIG. 7. The support plate 28 may be an annular plate structure. In addition, an annular groove 281 is disposed on a top surface of the support plate 28, and the annular groove 281 is configured for partially inserting the skived fin plate 27. In this way, sealing performance of the skived fin plate 27 and the support plate 28 can be improved, and relative positions of the skived fin plate 27 and the support plate 28 can be positioned. It may be understood that a bottom surface of the support plate 28 and a bottom surface of the skived fin plate 27 jointly form a bottom surface of the main part 21, and are configured to contact the heat generating component.

Still refer to FIG. 7. The skived fin plate 27 may include a bottom plate part 271 and a skived fin part 272. The skived fin part 272 is disposed on a top surface of the bottom plate part 271 and is located in the heat exchange cavity. The skived fin part 272 is made of a heat-conducting material, and the skived fin part 272 is configured to form a skived fin microchannel structure, thereby increasing a heat exchange area between the cooling medium and the heat generating component, and helping improve a heat exchange capability of the heat exchange assembly 20.

Still refer to FIG. 7. When the annular groove 281 is disposed on the top surface of the support plate 28, the bottom plate part 271 may include a first bottom plate section 2711 and a second bottom plate section 2712 that are stacked. The first bottom plate section 2711 is located above the second bottom plate section 2712 and is configured to be inserted into the annular groove 281. The second bottom plate section 2712 is inserted into the support plate 28. A bottom end face of the second bottom plate section 2712 may be flush with the bottom surface of the support plate 28, which can ensure that the heat generating component is in contact with the skived fin plate 27.

FIG. 8 is a three-dimensional diagram of a cover plate in a first direction according to an embodiment of this application. As shown in FIG. 6 and FIG. 8, a positioning block 43 may be extended from a bottom surface of the cover plate 26, and correspondingly, a second positioning groove 44 for inserting the positioning block 43 is disposed on the top surface of the support plate 28, so that relative positions of the support plate 28 and the cover plate 26 can be positioned.

It may be understood that positions of the positioning block 43 and the second positioning groove 44 may alternatively be interchanged, that is, the second positioning groove 44 is disposed on the bottom surface of the cover plate 26, and the positioning block 43 is disposed on the top surface of the support plate 28.

It should be noted that, because the annular groove 281 is disposed on the top surface of the support plate 28, as shown in FIG. 6, when the second positioning groove 44 is disposed on the support plate 28, the second positioning groove 44 may be connected to the annular groove 281. This helps reduce a processing difficulty of the support plate 28.

There are at least two positioning blocks 43, and the at least two positioning blocks 43 are spaced from each other in a circumferential direction of the cover plate 26. In other words, the at least two positioning blocks 43 are disposed around the skived fin plate 27. A quantity of second positioning grooves 44 is the same as a quantity of positioning blocks 43, and a position of the second positioning groove 44 adapts to a position of the positioning block 43. This is not specifically limited herein. For example, as shown in FIG. 8, there are four positioning blocks 43 that are respectively disposed at four corners of the cover plate 26. Correspondingly, as shown in FIG. 6, four second positioning grooves 44 are disposed at four corners of the support plate 28.

The cover plate 26 may be fastened to the support plate 28 in a manner of threaded connection, welding, or the like. For example, in some embodiments, as shown in FIG. 6 and FIG. 7, the heat exchange assembly 20 may further include a fastening plate 41 and a plurality of screws 42. A plurality of threaded holes for thread fitting with the screws 42 are spaced from each other on the fastening plate 41 in a circumferential direction. A plurality of first fastening holes are spaced from each other on the cover plate 26 in a circumferential direction, a plurality of second fastening holes are spaced from each other on the support plate 28 in a circumferential direction, and the plurality of first fastening holes are in one-to-one correspondence with the plurality of second fastening holes. Each screw 42 passes through a corresponding first fastening hole and a corresponding second fastening hole, and is connected to the fastening plate 41 through a thread.

As shown in FIG. 8, the fastening plate 41 covers the cover plate 26, and the liquid inlet 23 and the liquid outlet 24 are disposed on the cover plate 26. Therefore, a first opening 411 and a second opening 412 are provided on the fastening plate 41, the liquid inlet 23 is exposed in the first opening 411, and the liquid outlet 24 is exposed in the second opening 412, so that the liquid inlet 23 and the liquid outlet 24 are respectively connected to pipes.

FIG. 9 is a three-dimensional diagram of a cover plate in a second direction according to an embodiment of this application. In a possible implementation, as shown in FIG. 9, to separately connect the liquid inlet 23 and the liquid outlet 24 to the cooling medium supply apparatus, a liquid inlet connector 51 and a liquid outlet connector 52 may be disposed on the cover plate 26. The liquid inlet connector 51 is connected to the liquid inlet 23, and the liquid outlet connector 52 is connected to the liquid outlet 24. In addition, both the liquid inlet connector 51 and the liquid outlet connector 52 may be a threaded pipe connector, thereby helping improve a speed of connecting the liquid inlet connector 51 and the liquid outlet connector 52 to the pipes.

In a possible implementation, as shown in FIG. 7, the heat exchange assembly 20 may further include a sealing ring 29, and a sealing groove 261 for inserting a part of the sealing ring 29 is disposed on a bottom end face of the cover plate 26, so that the sealing ring 29 may abut against the skived fin plate 27 and the cover plate 26 separately. In this way, sealing performance of the skived fin plate 27 and the cover plate 26 can be improved.

In the foregoing content, a heat dissipation capability is improved by disposing the skived fin part 272. However, in addition to the skived fin part 272, in some embodiments, the skived fin part 272 may alternatively be replaced with a heat dissipation structure (not shown in the figure), and the heat dissipation structure includes a plurality of discretely distributed heat dissipation rods. A shape of the heat dissipation rod may be a square, a circle, a rhombus, or the like. The discrete rods may be arranged in sequence or crosswise. This is not limited herein. It may be understood that a gap disposed between the heat dissipation columns is used to improve the heat dissipation capability.

In some embodiments, the skived fin part 272 may alternatively be replaced with a fin structure (not shown in the figure). The fin structure includes a plurality of fins that are spaced from each other, and the fin is perpendicular to the bottom plate part 271, so that a straight fin channel is formed on the bottom plate part 271.

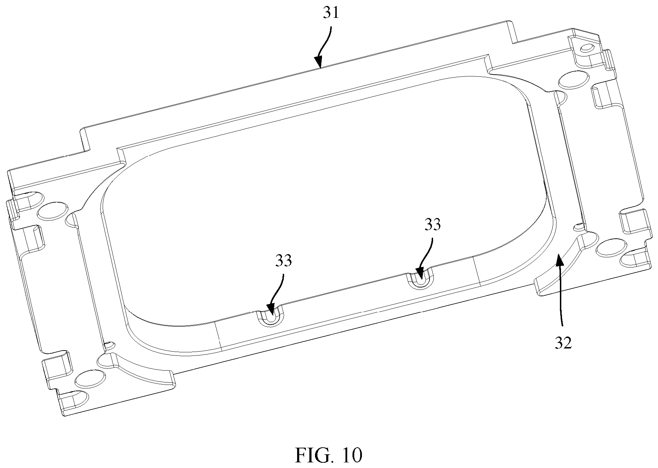

FIG. 10 is a three-dimensional diagram of a holder according to an embodiment of this application. In a possible implementation, as shown in FIG. 10, the body part 31 may be of an annular structure, the first fitting part 32 is a first positioning groove disposed on the bottom surface of the body part 31, and the first positioning groove is configured for inserting the positioning part 22, so that the relative positions of the body part 31 and the main part 21 are positioned.

It may be understood that a rectangular shape of the first positioning groove may be determined based on a structure of the positioning part 22. For example, when the positioning part 22 is of a rectangular annular structure, a structure of the first positioning groove may be shown in FIG. 10. Alternatively, in some embodiments, the first positioning groove may be a rectangular groove. This is not limited herein.

Certainly, a structure of the body part 31 may alternatively not be an annular structure. For example, in a possible implementation, the body part 31 may include two holder bodies (not shown in the figure), and one first fitting part 32 is disposed on a bottom surface of each holder body.

When the cold plate assembly 10 dissipates heat for the heat generating component, the two holder bodies are disposed on two opposite ends of the main part 21. The two holder bodies may be fastened to the CPU socket. Both the two holder bodies are located on the top surface of the positioning part 22. The positioning part 22 and the first fitting part 32 may fit each other to position relative positions of the holder body and the positioning part 22. The two holder bodies may enable the main part 21 to abut against the heat generating component, to fasten the heat exchange assembly 20 to the heat generating component.

It may be understood that the body part 31 may be fastened to the CPU socket in a manner of threaded connection, clamping, or the like. This is not specifically limited herein.

In descriptions of embodiments of this application, it should be noted that, unless otherwise explicitly stipulated and restricted, the terms "mount", "interconnect", and "connect" should be understood in a broad sense. For example, a connection may be a fixed connection, or may be an indirect connection through an intermediate medium, or may be an internal communication between two components, or may be an interaction relationship between two components. A person of ordinary skill in the art may understand specific meanings of the foregoing terms in embodiments of this application based on specific cases.

In the specification, claims, and accompanying drawings of embodiments of this application, the terms "first", "second", "third", "fourth", and so on (if existent) are intended to distinguish between similar objects but do not necessarily indicate a specific order or sequence.

## Claims

1. A heat exchange assembly, comprising a main part and a positioning part, wherein
the main part has a heat exchange cavity that is configured to accommodate a cooling medium, and a liquid inlet and a liquid outlet that are connected to the heat exchange cavity; and
the positioning part is configured to fit a first fitting part disposed on a holder, to position relative positions of the holder and the heat exchange assembly.

2. The heat exchange assembly according to claim 1, wherein the positioning part is sleeved on the main part and defines a step surface together with a side wall of the main part.

3. The heat exchange assembly according to claim 1, wherein there are at least two positioning parts, and the at least two positioning parts are spaced from each other in a circumferential direction of the main part.

4. The heat exchange assembly according to any one of claims 1 to 3, wherein the heat exchange assembly further comprises a fastening part, the fastening part is disposed on one of the main part and the positioning part, and the fastening part is configured to fit a second fitting part disposed on the holder, to fasten the heat exchange assembly and the holder.

5. The heat exchange assembly according to claim 4, wherein the fastening part is disposed on the main part, one of the fastening part and the second fitting part is an elastic bump, and the other is a fitting groove for inserting the elastic bump.

6. The heat exchange assembly according to claim 4, wherein the fastening part is disposed on the positioning part, one of the fastening part and the second fitting part is a clamping hook, and the other is a clamping groove or a clamping block clamped to the clamping hook.

7. The heat exchange assembly according to any one of claims 1 to 6, wherein the heat exchange assembly comprises a cover plate, a skived fin plate, and a support plate; and
the cover plate, the skived fin plate, and a part of the support plate jointly define the heat exchange cavity and are used as the main part, the liquid inlet and the liquid outlet are disposed on the cover plate, and another part of the support plate is used as the positioning part.

8. A cold plate assembly, comprising a holder and the heat exchange assembly according to any one of claims 1 to 7, wherein
the holder comprises a body part and a first fitting part; and
when the cold plate assembly is configured to dissipate heat for a heat generating component, the first fitting part fits a positioning part of the heat exchange assembly to position relative positions of the holder and the heat exchange assembly, and the body part is configured to enable a main part of the heat exchange assembly to abut against the heat generating component.

9. The cold plate assembly according to claim 8, wherein the body part is of an annular structure, and the first fitting part is disposed on a bottom surface of the body part.

10. The cold plate assembly according to claim 8, wherein the body part comprises two holder bodies, and one first fitting part is disposed on a bottom surface of each holder body.

11. A terminal device, comprising a heat generating component and the cold plate assembly according to any one of claims 8 to 10, wherein the cold plate assembly is configured to dissipate heat for the heat generating component.

12. The terminal device according to claim 11, wherein the terminal device is a server.
